# EUROPEAN PATENT SPECIFICATION

(11) **EP 3 133 750 B1**
(45) Date of publication and mention of the grant of the patent: **20.02.2019**
(21) Application number: 14896608.8
(22) Date of filing: 30.06.2014
(51) Int. Cl.: H04B 10/50, H01S 5/0683, H04B 10/272, H04B 10/564

(54) **LASER BURST CONTROL CIRCUIT AND METHOD**
LASERIMPULSSTEUERUNGSSCHALTUNG UND -VERFAHREN
CIRCUIT DE COMMANDE DE SALVE LASER, ET PROCÉDÉ

(43) Date of publication of application: 22.02.2017
(73) Proprietor: Source Photonics (Chengdu) Co. Ltd., Chengdu, Sichuan 611731 (CN)
(72) Inventor: JIANG, Xu, Chengdu Sichuan 611731 (CN); SONG, Yuan, Chengdu Sichuan 611731 (CN); ZHANG, Shuyuan, Chengdu Sichuan 611731 (CN); XU, Yuanzhong, Chengdu Sichuan 611731 (CN)
(74) Representative: Gille Hrabal
(86) International application number: PCT/CN2014/081129
(87) International publication number: WO 2016/000119

(56) References cited:
- CN-A- 101 436 902
- CN-A- 102 098 106
- CN-A- 102 546 028
- CN-U- 202 160 180
- CN-U- 202 177 841
- CN-U- 202 177 841
- US-A1- 2002 027 690
- US-A1- 2005 271 099
- US-A1- 2005 271 099
- US-A1- 2007 286 609
- US-B1- 7 174 099

## Description

### FIELD OF THE INVENTION

This invention relates to the field of laser devices, especially to laser burst-mode control circuit and the method thereof.

### DISCUSSION OF THE BACKGROUND

In conventional burst-mode laser driver circuits, a laser device cannot operate in burst-mode without burst-mode laser drivers. However, with regard to 10G or higher speed laser devices, such as DFB laser devices (Distributed Feedback Laser) or EMLs (Electro-absorption Modulated Laser), there are only continuous-mode laser drivers for them. With the development of 10G PON (Passive Optical Network) application, it needs ONU (Optical Network Unit) products supporting 10G or higher speed to meet the requirement of PON systems for burst-mode operation.

Some examples of burst-mode control systems in prior arts can be found in US 2005/271099A1, US 2002/027690 A1, CN 202177841U, etc.

### SUMMARY OF THE INVENTION

This invention provides a laser burst-mode control circuit as described in claim 1, as well as some embodiments according to its dependent claims.

This invention further provides a method of controlling a laser having a burst mode as described in claim 11, as well as some embodiments according to its dependent claims.

Relative to the prior art, the present invention advantageously provides:
1. In this invention, burst-mode laser driver is replaced by laser device fast response under the control of external switch circuits. This invention can be used to meet the requirement of PON systems for the burst-mode of ONUs, especially for high speed signals, such as 10G PON applications;
2. Low cost and easy implement, and adaptability for both DFB laser devices and EMLs, and ensuring ACP loop fast creation and operation in normal condition by providing bandwidth switching using switches and filter circuits.

### BRIEF DESCRIPTION OF THE DRAWINGS

FIG.1 is a block diagram showing circuit design according to the present invention.
FIG.2 is a diagram showing an EML burst-mode control circuit according to the present invention.
FIG.3 is a diagram showing a DFB burst-mode control circuit according to the present invention.
FIG.4 is a diagram showing a bandwidth-select circuit according to the present invention.
FIG.5 is a diagram showing a controlling sequential logic according to the present invention.

### EMBODIMENTS

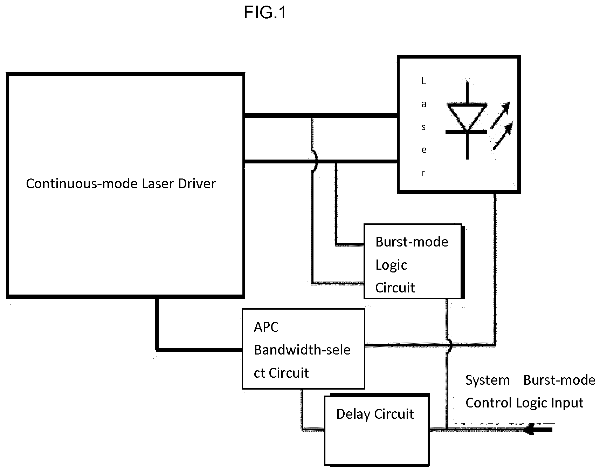

Referring to FIG.1, the present invention provides a laser burst-mode control circuit. In this invention, with an APC loop having an additional burst-mode control circuit, and a Switch in series and parallel connection with a diode and a laser, a continuous-mode laser driver is enabled to operate in burst-mode by turning the switch on or off via an external logic. Burst-mode control manages the Switch and a bandwidth-select circuit using high or low logic level input, wherein the laser will be disabled and the bandwidth-select circuit will enter fast-track mode if high level is inputted; the laser will provide regular optical signals and the bandwidth-select circuit will enter slow-track mode thereby enabling the APC loop to operate normally, if low level is inputted.

### Embodiment 1

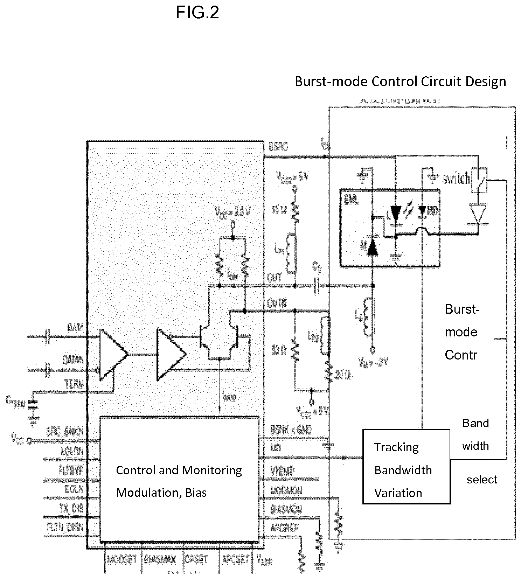

Referring to FIG.2, EML laser device is employed to implement a burst-mode control circuit. In the laser burst-mode control circuit portion of FIG.2, this portion provides laser devices with burst-mode control by turning a switch on or off under the control of external logic while the Switch is in serial connection with a diode and then in parallel connection with an EML.

In addition, the burst-mode control manages the Switch and bandwidth-select circuit via high or low logic level input into the PON system, wherein TTL (Transistor-Transistor Logic) high level is between 2.4V and 3.3V while the low level is between 0V and 0.8V. The input control logic is system input. The system provides high or low level input according to requirements to determine whether to enable ONU.

The EML will be disabled and the bandwidth-select circuit will enter fast-track mode if high level is inputted; the EML will provide regular optical signals and the bandwidth-select circuit will enter slow-track mode if low level is inputted, thereby ensuring optical power stable through the APC loop.

### Embodiment 2

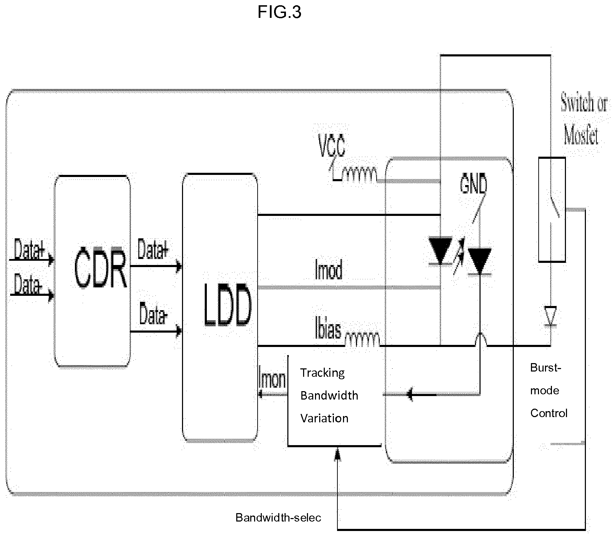

FIG.3 is a circuit diagram of the present invention employing DFB lasers. With regard to laser burst-mode control circuit portion, this portion is configured to provide DFB lasers with burst-mode control by external logic turning a switch on or off, wherein the Switch(or a field effect transistor)is in serial connection with a diode and then in parallel connection with the DFB laser.

Burst-mode control manages the switch and bandwidth-select circuit by high or low level input, wherein TTL (Transistor-Transistor Logic) high level is between 2.4V and 3.3V while the low level is between 0V and 0.8V. The DFB laser will be disabled and the bandwidth-select circuit will enter fast-track mode if high level is inputted; the DFB laser will provide regular optical signals and the bandwidth-select circuit will enter slow-track mode if low level is inputted, thereby ensuring optical power stable through the APC loop.

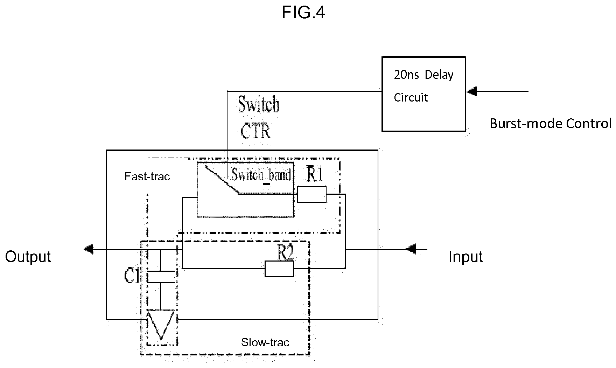

FIG.4 is a circuit diagram showing a bandwidth-select circuit in accordance with embodiment 1 and 2 of the present invention. The bandwidth-select circuit comprises two functional blocks: one for high-low bandwidth, comprising fast-track mode and slow-tack mode; another for delay circuit, configured to delay burst-mode control logic input for 20ns to operate the APC loop in fast-track mode in 20ns before the laser is enabled, that is to say, APC can be quickly built and the laser provides a stable output power, then APC enter slow-track mode thereby enabling the laser to operate normally in various code patterns.

Resistance R1, R2 and capacitance C1 are alternative bandwidth parameters, wherein R1, switch_band and C1 form a fast-track circuit while R2 and C1 form a slow-track circuit. The greater the time constant τ =R*C for RC is, the slower the track speed is, and vice versa.

When the switch is turned on, R1 and R2 will be in parallel, if R1 is at 10 10ohm and R2 is at 200ohm, C1 will be at 0.01uF, and RC constant for fast-track circuit will be around R1*C1=0.1; when the switch is turned off, RC constant for fast-track circuit will be about R1*C1=0.1; the speed of the fast-track is 20 times higher than that of the slow-track, but the slow-track circuit can average input signals better to keep optical output power stable when burst-mode signals is used to produce light.

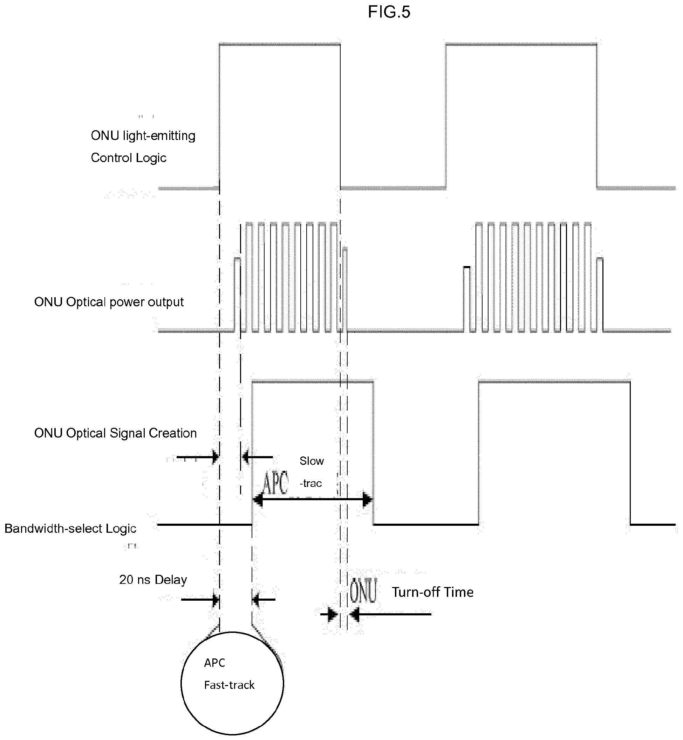

FIG.5 is a diagram of logic control sequence chart according to the present invention. if logic input to a PON system, ONU light-emitting logic, is high, the Switch in FIG.2 and 3 will be disconnected; ONU transmitter provides optical signals such that the laser driver enables the laser normally, meanwhile the bandwidth-select logic remains at low level in 20 ns before the optical signal is produced, that is to say, Switch CTR(Switch control) in FIG.4 keeps Switch_band closed while the bandwidth-select circuit is in fast-track mode; when ONU optical signal output is stable, the bandwidth-select logic will remain at high level, then Switch CTR(Switch control) in FIG.4 keeps Switch_band open, and the bandwidth-select circuit stays in slow-track mode, thereby keeping optical signals from the laser stable.
when logic input to a PON system, ONU light-emitting logic, becomes low, the Switch will be turned on, the ONU transmitter disables optical signal output from the laser, while Switches in FIG.2 and 3 are closed, the laser will be in parallel connection with the diode, and then decreasing voltage/current at both ends of the laser results in no optical output from the laser, and the bandwidth-select circuit will remain in fast-track mode until ONU optical signals provide high control logic next time.

In this invention, instead of laser drivers having a function of burst-mode, laser drivers can always operate in continuous-mode by laser fast-response under the control of external switch circuits. Without burst-mode laser drivers, this invention can be used to meet the requirement of PON systems for the burst-mode of ONUs, especially for high speed signals, such as 10G PON applications. This solution is advantaged by low cost and easy implement and adaptability for both DFB laser devices and EMLs. This invention ensures ACP loop fast creation and operation in normal condition by providing bandwidth switching using switches and filter circuits.

## Claims

1. A burst-mode laser control circuit, comprising:
a) an automatic power control (APC) loop containing a bandwidth-select circuit for selecting track mode;
b) a laser;
c) a diode; and
d) a burst-mode control circuit comprising a switch in series with the diode and parallel to the laser, the switch being turned on or off by external logic;
when the switch is turned on, the laser is disabled and the bandwidth-select circuit enters a first track mode;
when the switch is turned off, the laser is able to provide optical outputs, and the bandwidth-select circuit enters a second track mode;
wherein the bandwidth-select circuit is configured to track its input signals faster in the first track mode than that in the second track mode;
thereby providing burst-mode control of the laser.

2. The burst-mode laser control circuit of claim 1, wherein said switch and said bandwidth-select circuit are enabled or disabled with a high or low logic level input.

3. The burst-mode laser control circuit of claim 2, wherein said bandwidth-select circuit comprises a high-low bandwidth-select circuit and a delay circuit.

4. The burst-mode laser control circuit of claim 3, wherein said switch is configured to disable the diode and the bandwidth-select circuit is configured to enter the first track mode when the external logic provides a high logic level, and the laser is able to provide optical signals and the bandwidth-select circuit is configured to enter the second track mode when the external logic provides a low logic level.

5. The burst-mode laser control circuit of claim 3, wherein said delay circuit comprises delay control logic configured to operate the APC loop in the first track mode before enabling the laser, and to operate the APC loop in the second track when enabling the laser to operate.

6. The burst-mode laser control circuit of claim 5, wherein said delay control logic is configured to enable the APC loop to control power to the laser before the laser is enabled, thereby providing a stable laser power output when the laser begins to operate.

7. The burst-mode laser control circuit of claim 1, wherein the APC loop comprises the laser, a continuous-mode laser driver, and the bandwidth-select circuit.

8. The burst-mode laser control circuit of claim 1, wherein the laser comprises a burst mode laser.

9. The burst-mode laser control circuit of claim 8, wherein the burst mode laser comprises a distributed feedback (DFB) laser or an electro-amplitude modulated laser (EML).

10. The burst-mode laser control circuit of claim 8, further comprising a continuous mode laser driver, receiving a control signal from the APC loop and providing a driving signal to the laser.

11. A method of controlling a laser having a burst mode, comprising:
a) when a logic input to an optical network unit (ONU) in a passive optical network (PON) has a first logic state, placing a bandwidth-select circuit in a first track mode for a predetermined period of time and disconnecting a switch, the ONU comprising the burst-mode laser control circuit of claim 1;
b) after the predetermined period of time, driving the laser using a laser driver and transmitting an optical signal from the laser normally;
c) when the optical signal from the laser is stable, placing the bandwidth-select circuit in a second track mode, wherein the bandwidth-select circuit tracks its input signals faster in the first track mode than that in the second track mode;
d) when the logic input to the ONU has a second state, turning on the switch to disable the optical signal from the laser and connect the laser in parallel with the diode; and
e) placing the bandwidth-select circuit in the first track mode when the logic input has the first logic state again.

12. The method of claim 11, wherein the first logic state is a low logic level, and the second logic state is a high logic level.

13. The method of claim 11, wherein the predetermined period of time is about 20 ns.

14. The method of claim 11, wherein after said logic input transitions to the second state, the bandwidth-select circuit stays in the first track mode for the predetermined period of time.

15. The method of claim 11, wherein placing the bandwidth-select circuit in the second track mode keeps optical signals from the laser stable.

16. The method of claim 11, wherein decreasing a voltage/current at a cathode and an anode of the laser results in no optical signal from the laser.

## Patentansprüche

1. Burst-Modus-Lasersteuerungsschaltung, umfassend:
a) eine automatische Leistungssteuerungsschleife (APC), die eine Bandbreitenauswahlschaltung zum Auswählen eines Track-Modus enthält;
b) einen Laser;
c) eine Diode; und
d) eine Burst-Modus-Steuerschaltung, die einen Schalter in Reihe mit der Diode und parallel zum Laser umfasst, wobei der Schalter durch externe Logik ein- oder ausgeschaltet wird;
wobei, wenn der Schalter eingeschaltet wird, der Laser deaktiviert wird und die Bandbreitenauswahlschaltung in einen ersten Track-Modus gelangt;
wobei, wenn der Schalter ausgeschaltet wird, der Laser optischen Output bereitstellen kann, und die Bandbreitenauswahlschaltung in einen zweiten Track-Modus gelangt;
wobei die Bandbreitenauswahlschaltung konfiguriert ist, um ihre Eingangssignale im ersten Track-Modus schneller zu verfolgen als im zweiten Track-Modus;
wodurch eine Burst-Mode-Steuerung des Lasers erreicht wird.

2. Burst-Modus-Lasersteuerungsschaltung nach Anspruch 1, wobei der Schalter und die Bandbreitenauswahlschaltung mit einem hohen oder niedrigen Logik-Level-Eingang aktiviert oder deaktiviert werden.

3. Burst-Modus-Lasersteuerungsschaltung nach Anspruch 2, wobei die Bandbreitenauswahlschaltung eine Hoch-Niedrig-Bandbreitenauswahlschaltung und eine Verzögerungsschaltung umfasst.

4. Burst-Modus-Lasersteuerungsschaltung nach Anspruch 3, wobei der Schalter konfiguriert ist, um die Diode zu deaktivieren, und die Bandbreitenauswahlschaltung konfiguriert ist, um in den ersten Track-Modus zu gelangen, wenn die externe Logik einen hohen Logik-Level bereitstellt, und der Laser in der Lage ist, optische Signale bereitzustellen, und die Bandbreitenauswahlschaltung konfiguriert ist, um in den zweiten Track-Modus zu gelangen, wenn die externe Logik einen niedrigen Logik-Level bereitstellt.

5. Burst-Modus-Lasersteuerungsschaltung nach Anspruch 3, wobei die Verzögerungsschaltung eine Verzögerungssteuerungslogik umfasst, die konfiguriert ist, um die APC-Schleife im ersten Track-Modus zu betreiben, bevor der Laser aktiviert wird, und um die APC-Schleife in dem zweiten Track-Modus zu betreiben, wenn der Laser zum Betrieb aktiviert wird.

6. Burst-Modus-Lasersteuerungsschaltung nach Anspruch 5, wobei die Verzögerungssteuerungslogik so konfiguriert ist, dass die APC-Schleife Leistung zum Laser steuern kann, bevor der Laser aktiviert wird, wodurch ein stabiler Laserleistungs-Output bereitgestellt wird, wenn der Laser mit dem Betrieb beginnt.

7. Burst-Modus-Lasersteuerungsschaltung nach Anspruch 1, wobei die APC-Schleife den Laser, einen Kontinuierlich-Modus-Lasertreiber und die Bandbreitenauswahlschaltung umfasst.

8. Burst-Modus-Lasersteuerungsschaltung nach Anspruch 1, wobei der Laser einen Burst-Modus-Laser umfasst.

9. Burst-Modus-Lasersteuerungsschaltung nach Anspruch 8, wobei der Burst-Modus-Laser einen Distributed Feedback (DFB) Laser oder einen Electro-Amplitude Modulated Laser (EML) umfasst.

10. Burst-Modus-Lasersteuerungsschaltung nach Anspruch 8, ferner umfassend einen Kontinuierlich-Modus-Lasertreiber, der ein Steuersignal von der APC-Schleife empfängt und dem Laser ein Antreibsignal bereitstellt.

11. Verfahren zum Steuern eines Lasers, der einen Burst-Modus hat, umfassend:
a) wenn ein Logikeingang zu einer optischen Netzwerkeinheit (ONU) in einem passiven optischen Netzwerk (PON) einen ersten Logik-Zustand aufweist, Bringen einer Bandbreitenauswahlschaltung in einen ersten Track-Modus für eine vorbestimmte Zeitspanne und Trennen eines Schalters, wobei die ONU die Burst-Modus-Lasersteuerschaltung nach Anspruch 1 umfasst;
b) nach der vorbestimmten Zeitspanne, Antreiben des Lasers unter Verwendung eines Lasertreibers und Übertragen eines optischen Signals vom Laser in normaler Weise;
c) wenn das optische Signal vom Laser stabil ist, Bringen der Bandbreitenauswahlschaltung in einen zweiten Track-Modus, wobei die Bandbreitenauswahlschaltung ihre Eingangssignale im ersten Track-Modus schneller verfolgt als im zweiten Track-Modus;
d) wenn der Logikeingang zur ONU einen zweiten Zustand aufweist, Einschalten des Schalters, um das optische Signal vom Lasers zu deaktivieren und den Laser parallel zur Diode zu verbinden; und
e) Bringen der Bandbreitenauswahlschaltung in den ersten Track-Modus, wenn der Logikeingang wieder den ersten Logikzustand aufweist.

12. Verfahren nach Anspruch 11, wobei der erste Logikzustand ein niedriger Logik-Level ist und der zweite Logikzustand ein hoher Logik-Level ist.

13. Verfahren nach Anspruch 11, wobei die vorbestimmte Zeitspanne ungefähr 20 ns beträgt.

14. Verfahren nach Anspruch 11, wobei nach den Logikeingangsübergängen in den zweiten Zustand die Bandbreitenauswahlschaltung für die vorbestimmte Zeitspanne im ersten Track-Modus bleibt.

15. Verfahren nach Anspruch 11, wobei Bringen der Bandbreitenauswahlschaltung in den zweiten Track-Modus optische Signale vom Laser stabil hält.

16. Verfahren nach Anspruch 11, wobei Verringern einer Spannung / eines Stroms an einer Kathode und einer Anode des Lasers zu keinem optischen Signal vom Laser führt.

## Revendications

1. Circuit de commande en mode rafale de laser, comprenant :
a) une boucle de commande de puissance automatique (APC) comprenant un circuit de sélection de bande passante pour sélectionner le mode trace ;
b) un laser ;
c) une diode ; et
d) un circuit de commande en mode rafale comprenant un commutateur en série avec la diode et parallèle au laser, le commutateur étant activé ou désactivé par une logique externe ;
si le commutateur est activé, le laser sera désactivé et le circuit de sélection de bande passante entrera en un premier mode trace ;
si le commutateur est désactivé, le laser sera capable de fournir des résultats optiques et le circuit de sélection de bande passante entrera en un deuxième mode trace ;
dans lequel le circuit de sélection de bande passante est configuré pour tracer ses signaux d'entrée plus vite en premier mode trace qu'en deuxième mode trace ; et il fournit ainsi une commande en mode rafale du laser.

2. Circuit de commande en mode rafale de laser selon la revendication 1, dans lequel ledit commutateur et ledit circuit de sélection de bande passante sont activés ou désactivés par une entrée de type niveau logique élevé ou faible.

3. Circuit de commande en mode rafale de laser selon la revendication 2, dans lequel ledit circuit de sélection de bande passante comprend un circuit de sélection de bande passante élevée ou faible et un circuit à retard.

4. Circuit de commande en mode rafale de laser selon la revendication 3, dans lequel ledit commutateur est configuré pour désactiver la diode et le circuit de sélection de bande passante est configuré pour entrer en premier mode trace, si la logique externe fournit un niveau de logique élevé et le laser est capable de fournir des signaux optiques, et le circuit de sélection de bande passante est configuré pour entrer en deuxième mode trace, si la logique externe fournit une niveau de logique faible.

5. Circuit de commande en mode rafale de laser selon la revendication 3, dans lequel le circuit à retard comprend une logique de commande à retard configurée pour faire fonctionner la boucle APC en premier mode trace avant d'activer le laser et pour faire fonctionner la boucle APC en deuxième mode trace, si le laser est activé pour fonctionner.

6. Circuit de commande en mode rafale de laser selon la revendication 5, dans lequel la logique de commande à retard est configurée pour initier la boucle APC à contrôler la puissance fournie au laser avant que le laser soit activé et pour ainsi fournir une puissance de sortie stable du laser, quand le laser commence à fonctionner.

7. Circuit de commande en mode rafale de laser selon la revendication 1, dans lequel la boucle APC comprend le laser, un pilote de laser en mode continu et le circuit de sélection de bande passante.

8. Circuit de commande en mode rafale de laser selon la revendication 1, dans lequel le laser comprend un laser à mode rafale.

9. Circuit de commande en mode rafale de laser selon la revendication 8, dans lequel le laser à mode rafale comprend un laser à rétroaction répartie (DFB) ou un laser modulé à amplitude électrique (EML).

10. Circuit de commande en mode rafale de laser selon la revendication 8, comprenant en outre un pilote de laser en mode continu, qui reçoit un signal de la boucle APC et fournit un signal de pilotage au laser.

11. Procédé de commande d'un laser comprenant un mode rafale, comprenant les étapes de :
a) si une entrée logique dans une unité de réseau optique (ONU) dans un réseau optique passif (PON) comprend un premier état logique, mettre un circuit de sélection de bande passante en un premier mode trace pour une période de temps prédéterminée et déconnecter un commutateur, l'ONU comprenant le circuit de commande en mode rafale de laser selon la revendication 1 ;
b) après la période de temps prédéterminée, piloter le laser en utilisant un pilote de laser et transmettre un signal optique à partir du laser normalement ;
c) si le signal optique du laser est stable, mettre le circuit de sélection de bande passante en un deuxième mode trace, le circuit de sélection de bande passante traçant ses signaux d'entrée plus vite en premier mode trace qu'en deuxième mode trace ;
d) si l'entrée logique dans l'ONU comprend un deuxième état, activer le commutateur pour désactiver le signal optique du laser et connecter le laser en parallèle avec la diode ; et
e) mettre le circuit de sélection de bande passante en premier mode trace, si l'entrée logique comprend de nouveau le premier état logique.

12. Procédé selon la revendication 11, dans lequel le premier état logique est un niveau logique faible et le deuxième état logique est un niveau logique élevé.

13. Procédé selon la revendication 11, dans lequel la période de temps prédéterminée est environ 20 ns.

14. Procédé selon la revendication 11, dans lequel après que ladite entrée logique a passé en deuxième état, le circuit de sélection de bande passante reste en premier mode trace pendant la période de temps prédéterminée.

15. Procédé selon la revendication 11, dans lequel la mise du circuit de sélection de bande passante en deuxième mode trace maintient des signaux optiques du laser stables.

16. Procédé selon la revendication 11, dans lequel la diminution d'une tension/d'un courant à la cathode et à l'anode du laser résulte en la disparition de signaux optiques du laser.
